(19) Europäisches Patentamt

European Patent Office

Office européen des brevets

(11) **EP 0 981 160 A2**

(12) **EUROPÄISCHE PATENTANMELDUNG**

(43) Veröffentlichungstag:
**23.02.2000 Patentblatt 2000/08**

(51) Int. Cl.$^7$: **H01L 23/495**, H01L 23/64

(21) Anmeldenummer: **99115541.7**

(22) Anmeldetag: **02.08.1999**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **13.08.1998 DE 19836753**

(71) Anmelder:
**SIEMENS AKTIENGESELLSCHAFT**
**80333 München (DE)**

(72) Erfinder: **Buck, Martin**
**81243 München (DE)**

(54) **Zuleitungen mit einem definierten Widerstandswert für einen integrierten Halbleiterchip**

(57) An den Zuleitungen (Z) eines integrierten Halbleiterchips, die eine Verbindung zu externen Anschlüssen einer Versorgungsspannung herstellen, können durch hoch getaktete Stromimpulse Potentialschwankungen bis hin zu Resonanzschwingungen an einem internen Anschluß der jeweiligen Zuleitung (Z) angeregt werden. Zur Dämpfung dieser Potentialschwankungen wird für eine oder mehrere Zuleitungen (Z) ein Widerstandswert ($R_D$) vorgegeben, der groß genug ist, diese Potentialschwankungen zu dämpfen, jedoch klein genug ist, um auf der jeweiligen Zuleitung (Z) nur einen vorgegebenen maximal zulässigen Spannungsabfall zu verursachen. Der jeweilige Widerstand ($R_D$) kann durch Verwendung eines Materials mit einem entsprechenden spezifischen Widerstand oder durch Verkleinerung des Leiterquerschnitts (q) mit einer Einkerbung (K) entlang der Zuleitung (Z) erzielt werden.

FIG 1

**Beschreibung**

Die vorliegende Erfindung betrifft einen integrierten Halbleiterchip nach dem Oberbegriff des Patentanspruchs 1.

Ein Halbleiterbaustein, in dessen Gehäuse sich ein Siliziumchip mit chipinternen Anschlüssen zu einer oder mehreren auf dem Siliziumchip befindlichen integrierten Schaltungen befindet, ist üblicherweise mit Zuleitungen von einem oder mehreren solchen internen Anschlüssen zu einem oder mehreren Anschlüssen versehen, die sich außerhalb der Chipfläche befinden. Solche Anschlüsse können zum Beispiel Anschlüsse zu externen Spannungsversorgungen oder Verbindungen zu anderen Baugruppen sein, die sich beispielsweise auf einer Platine außerhalb des Bausteins befinden. Bei manchen Ausführungen sind die Zuleitungen an den Stellen, an denen sie mit den externen Anschlüssen kontaktiert sind (z.B. Kontakte auf der Platine), in einem rechten Winkel gebogen. Damit möglichst wenig Verlustleistung in den Zuleitungen des Chips entsteht, werden die Zuleitungen (Leads) im allgemeinen möglichst niederohmig ausgeführt.

Immer höhere Datenraten bei integrierten Halbleiterchips sind die Ursache für immer höhere Taktraten, mit denen der Chip betrieben wird. Bei jedem Takt wird eine gewisse Energie auf dem Chip verbraucht, wodurch Stromimpulse an den Zuleitungen der Spannungsversorgung hervorgerufen werden, die mit höheren Taktraten entsprechend schneller und steiler werden. Die Zuleitungen von integrierten Schaltungen eines Chips zu externen Versorgungspotentialen einer Versorgungsspannung weisen Leitungsinduktivitäten auf, die zusammen mit den Kapazitäten auf dem Chip ein schwingfähiges System bilden. Durch schnellere und steilere Stromimpulse auf den Zuleitungen steigt auch der Spannungsabfall an diesen Induktivitäten und Kapazitäten an, wodurch Schwingungen angeregt werden, die bis hin zu unerwünschten Resonanzschwingungen führen können. So kann der damit verbundene Einfluß auf die interne Spannungsversorgung nicht mehr vernachlässigt werden. Durch steile Stromimpulse können somit Potentialschwankungen, die periodisch schwingen und bis hin zu Resonanzen führen können, an den internen Anschlüssen der jeweiligen Zuleitung des Chips angeregt werden, die dessen Funktion beeinträchtigen können. Da verschiedene Funktionsgruppen des Chips, wie Logikschaltungen oder Ausgangstreiber, mit der Versorgungsspannung verbunden sind, können Potentialschwankungen an der internen Versorgungsspannung einer Funktionsgruppe auch Einfluß nehmen auf die Spannungsversorgung der jeweils anderen Funktionsgruppen. Je nach Empfindlichkeit der jeweiligen Schaltungen gegen Unregelmäßigkeiten in der Versorgungsspannung kann die Funktion des Chips dabei gefährdet sein.

Bisher wurde versucht, Halbleiterchips so zu gestalten, daß Potentialschwankungen an der internen Spannungsversorgung den Betrieb des Halbleiterchips nicht beeinflussen. Das bedeutet, daß die Schaltgeschwindigkeit eines Chips nur so hoch sein darf, daß gerade noch vertretbare Spannungsschwankungen verursacht werden. Dadurch entstehen jedoch Einbußen in der Geschwindigkeit der Datenübertragung eines Chips. Um die maximal zulässige Datenübertragungsrate des Halbleiterchips optimal an eine Anwendung anzupassen, ist es demnach erforderlich, die Umgebungsbedingungen des Chips (z.B. Kapazitäten, Induktivitäten) je nach Anwendung zu spezifizieren. Dies ist aufgrund der Vielzahl an Einflußgrößen in einer digitalen Schaltung jedoch kaum möglich. Außerdem beschränkt man sich durch eine solche Maßnahme auf einen definierten Anwendungsbereich des Halbleiterchips. Eine andere Möglichkeit ist, Potentialschwankungen an einem internen Anschluß einer Zuleitung zu dämpfen, indem auf dem Chip ein Dämpfungswiderstand mit einem definiertem Wert vorgesehen wird. Ein solcher Widerstand übernimmt in einer integrierten Schaltung ansonsten keine weiteren Aufgaben. Dadurch ist zur Unterbringung eines derartigen Widerstandes zusätzliche wertvolle Fläche auf dem Chip notwendig.

Die Aufgabe der vorliegenden Erfindung ist es, Potentialschwankungen an einem internen Anschluß einer Zuleitung eines integrierten Halbleiterchips, die durch Stromimpulse auf der Zuleitung angeregt werden, so zu dämpfen, daß die interne Spannungsversorgung auch bei hohen Taktraten stabilisiert wird und die Funktion des Chips gewährleistet bleibt, ohne daß eine dafür bestimmte, zusätzlich erforderliche Chipfläche benötigt wird.

Die Aufgabe wird gelöst durch einen integrierten Halbleiterchip nach den Merkmalen des Patentanspruchs 1.

Vorteilhafte Aus- und Weiterbildungen sind in Unteransprüchen gekennzeichnet.

Im folgenden wird die Erfindung anhand von in der Zeichnung dargestellten Figuren näher erläutert.

Es zeigen:

Figur 1    eine schematische Darstellung eines Teils eines Halbleiterbausteins mit Zuleitungen Z (Leads) von internen Anschlüssen C eines Siliziumchips SP zu Anschlüssen außerhalb des Chips,

Figur 2    eine schematische Darstellung einer Zuleitung Z mit einer Verkleinerung des Leiterquerschnitts q (Einkerbung K) und das Ersatzschaltbild für den Leitungswiderstand $R_D$.

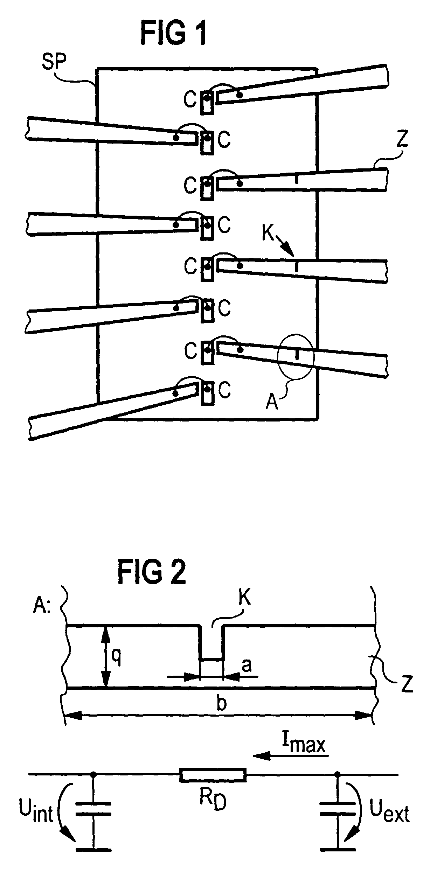

Figur 1 zeigt eine schematische Darstellung eines Teils eines Halbleiterbausteins mit Zuleitungen Z von internen Anschlüssen C eines Siliziumchips SP zu Anschlüssen außerhalb des Chips, die als sogenannte Leads herausgeführt sind. Zur Herstellung des elektrischen Kontakts zwischen den internen Anschlüssen C (Bondpads) des Siliziumchips SP und den Zuleitungen Z werden sogenannte Bonddrähte verwendet. Der Querschnitt einer Zuleitung Z ist nicht über der gesamten Länge gleich. Der Querschnitt an einem Ende der Zuleitung Z ist meist breiter als der Querschnitt am anderen Ende. Zwischen den beiden Enden verändert sich der Querschnitt gleichmäßig. Meist befindet sich das schmalere Ende an einem internen Anschluß C, das breitere Ende hingegen an einem externen Anschluß eines Halbleiterchips.

Wie eingangs erwähnt, wurden bisher Zuleitungen und damit auch Bonddrähte möglichst niederohmig ausgeführt, um möglichst wenig Verlustleistung im Leiter zu erzeugen. Statt dessen werden nun eine oder mehrere Zuleitungen Z so ausgeführt, daß sie einen vorgegebenen Widerstand haben. Dessen Wert $R_D$ ist so groß, daß Potentialschwankungen an einem internen Anschluß C der jeweiligen Zuleitung Z, die durch Stromimpulse auf der jeweiligen Zuleitung Z angeregt werden und die periodisch schwingen und bis hin zu Resonanzschwingungen führen können, genügend gedämpft werden. Der Wert $R_D$ ist jedoch klein genug, um auf der jeweiligen Zuleitung Z nur einen vorgegebenen maximal zulässigen Spannungsabfall bei einem maximalen Strom zu verursachen.

Figur 2 zeigt schematisch den Querschnitt q eines Abschnitts einer Zuleitung Z eines integrierten Halbleiterchips. Über einer im Verhältnis zur gesamten Länge der Zuleitung Z kurzen Strecke eines Teilstücks b kann der Querschnitt q als nahezu konstant angesehen werden. Die gezeigte Zuleitung Z weist einen vorgegebenen Dämpfungswiderstand auf, der im dargestellten Ersatzschaltbild durch den Leitungswiderstand $R_D$ zum Ausdruck kommt. Der maximal zulässige Wert eines derartigen Widerstands $R_D$ kann folgendermaßen dimensioniert werden:

$$R_{D\,max} = \frac{U_{ext}}{I_{max}} \cdot \frac{\alpha}{100\%} ,$$

wobei

$R_{Dmax}$ = maximal zulässiger Dämpfungswiderstand
$I_{max}$ = maximal auftretender Strom durch einen Pin des Halbleiterchips
$U_{ext}$ = extern angelegte Versorgungsspannung
$\alpha$ = prozentuale maximal zulässige Potentialschwankung der internen Versorgungsspannung

Der so definierte Widerstandswert $R_D$ wird in dem gezeigten Ausführungsbeispiel dadurch gewonnen, daß der Leiterquerschnitt q einer Zuleitung Z innerhalb eines abgegrenzten Abschnitts a entlang der Zuleitung Z verkleinert wird (Einkerbung K). Durch eine Verkleinerung des Leiterquerschnitts q an einer beliebigen Stelle wird der Widerstand der Zuleitung Z entsprechend vergrößert.

Die Induktivität eines Leiters wird mitbestimmt durch die Form des Leiterquerschnitts. So ist die Induktivität von bandförmigen Leitern, das heißt von Leitern, die sehr flach und verhältnismäßig breit sind, vergleichsweise niedrig. Durch die eingangs genannten Gründe ist es erstrebenswert, die Induktivität der Zuleitungen Z möglichst gering zu halten, weshalb die Zuleitungen Z zumeist möglichst breit ausgeführt werden. Aus diesem Grund ist es vorteilhaft, daß die Einkerbung K (das bedeutet, die Zuleitung Z wird an dieser Stelle schmaler) über einen im Verhältnis zur gesamten Länge der Zuleitung Z kurzen Abschnitt a erfolgt und damit die Induktivität nicht merklich vergrößert wird. Das Größenverhältnis zwischen der Länge des Abschnitts a mit der Einkerbung K und der Gesamtlänge der Zuleitung Z kann beispielsweise 1:1000 betragen.

Als technisches Mittel zur Verkleinerung eines Leiterquerschnitts kann ein Laser verwendet werden, der eine entsprechende Kerbe K in die jeweilige Zuleitung Z schneidet. Alternativ kann die jeweilige Einkerbung K auch durch Ätzen hergestellt werden. Beide Verfahren müssen nicht für diesen Zweck in einen Herstellungsprozeß neu eingeführt werden, da sie in ähnlicher Weise bereits bei anderen unterschiedlichen Prozeßschritten zur Herstellung eines Halbleiterchips verwendet werden (z.B. Einbrennen von Fuses in Speicherzellenfelder durch Laserlicht, Ätzen von unterschiedlichen Schichtebenen oder des Leadframes).

In einer anderen Ausführungsform kann der definierte Widerstandswert $R_D$ einer Zuleitung Z dadurch hergestellt werden, daß bei der Herstellung der jeweiligen Zuleitung Z ein Material mit einem entsprechenden spezifischen Widerstand verwendet wird, ohne daß dabei der Leiterquerschnitt q im gezeigten Teilstück b verändert wird.

In beiden Ausführungsformen wird keine wertvolle Chipfläche zur Dämpfung von Potentialschwankungen an einem internen Anschluß C einer Zuleitung Z benötigt, da Widerstände, die auf der Chipfläche angeordnet sind und die gleiche Funktion erfüllen, nicht benötigt werden.

**Patentansprüche**

1. Integrierter Halbleiterchip mit einer oder mehreren Zuleitungen (Z) zu einem oder mehreren externen Anschlüssen einer Versorgungsspannung, **dadurch gekennzeichnet,** daß

   - mindestens eine der Zuleitungen (Z) einen Widerstandswert ($R_D$) aufweist, der so groß ist, daß dadurch Potentialschwankungen an einem internen Anschluß (C) der jeweiligen Zuleitung (Z), die durch Stromimpulse auf der jeweiligen Zuleitung (Z) angeregt werden, genügend gedämpft werden, jedoch klein genug ist, um auf der jeweiligen Zuleitung (Z) nur einen vorgegebenen maximal zulässigen Spannungsabfall bei einem maximalen Strom ($I_{max}$) zu verursachen, und

- der Widerstandswert ($R_D$) der jeweiligen Zuleitung (Z) dadurch bewirkt wird, daß der Querschnitt (q) der jeweiligen Zuleitung (Z) innerhalb eines abgegrenzten Abschnitts (a), der klein gegenüber der gesamten Länge der Zuleitung (Z) ist, entlang der Zuleitung (Z) verkleinert ist.

2. Integrierter Halbleiterchip nach Anspruch 1, **dadurch gekennzeichnet,** daß der abgegrenzte Abschnitt (a) entlang einer Zuleitung (Z), in dem der Querschnitt (q) der jeweiligen Zuleitung (Z) verkleinert ist, eine Einkerbung (K) in der Zuleitung (Z) ist.

3. Integrierter Halbleiterchip nach Anspruch 2, **dadurch gekennzeichnet,** daß das Größenverhältnis zwischen der Länge des abgegrenzten Abschnitts (a) mit der Einkerbung (K) und der Gesamtlänge der Zuleitung (Z) 1:1000 beträgt.

4. Integrierter Halbleiterchip nach Anspruch 2, **dadurch gekennzeichnet,** daß die Einkerbung (K) in der jeweiligen Zuleitung (Z) durch Ätzen oder durch Schneiden mit einem Laser bewirkt wird.

## FIG 1

## FIG 2